Europäisches Patentamt

European Patent Office

Office européen des brevets

(11) Publication number: **0 054 740**
A2

# EUROPEAN PATENT APPLICATION

(21) Application number: 81109508.2

(22) Date of filing: 04.11.81

(51) Int. Cl.³: **G 11 C 17/00**

(30) Priority: 23.12.80 US 220208

(43) Date of publication of application: 30.06.82
Bulletin 82/26

(84) Designated Contracting States: **AT DE FR GB NL SE**

(71) Applicant: **AMERICAN MICROSYSTEMS, INCORPORATED, 3800 Homestead Road, Santa Clara, CA 95051 (US)**

(72) Inventor: **Wollesen, Donald L., 11950 Vallejo Drive, Saratoga, CA 95070 (US)**

(74) Representative: **Schmidt-Evers, Jürgen et al, Patentanwälte Dipl.-Ing.H.Mitscherlich Dipl.-Ing.K.Gunschmann Dr.rer.nat.W.Körber Dipl.-Ing.J.Schmidt-Evers, Steinsdorfstrasse 10 D-8000 München 22 (DE)**

(54) **Zener diode burn prom.**

(57) A semiconductor programmable read only memory device containing a plurality of memory cells is constructed using zener diodes as the programming means of each cell. A desired cell is programmed by shorting out the zener diode by causing excessive current flow during zener breakdown. Cells utilizing zener diodes as the programming means are smaller than prior art cells utilizing transistors as the programming means. Cells utilizing zener diodes as the programming means require relatively small amounts of current during programming, reducing the size of the access device required, and thus further reducing the size of the cell. The zener diodes used as the programming means of this invention are manufactured without additional process steps over conventional MOS process techniques.

0054740

ZENER DIODE BURN PROM

Donald L. Wollesen

BACKGROUND OF THE INVENTION

Field of the Invention

This invention relates to semiconductor memory devices, and more particularly to a programmable read only memory (PROM) device utilizing diffused zener diodes as the programming means.

Description of the Prior Art

Semiconductor programmable read only memories (PROMs) are well-known in the prior art. PROMs consist of an array of memory cells, each cell capable of storing one bit, which may be programmed after the PROM has been completely fabricated and assembled. Once an individual cell is programmed, it may not later be changed or "reprogrammed".

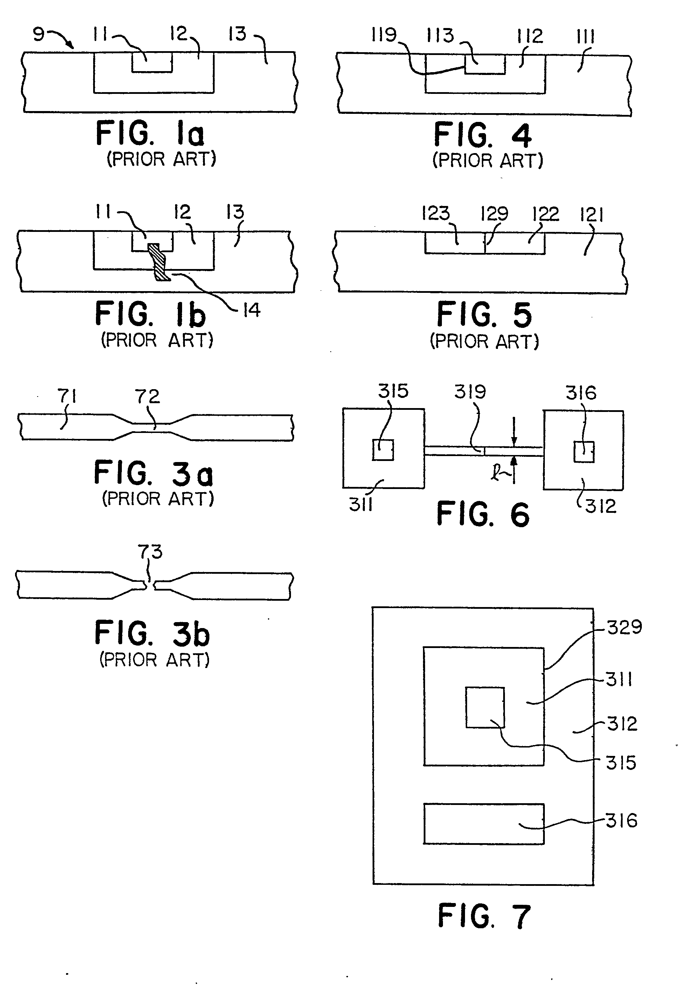

One common method of constructing PROMs is to use a bipolar transistor as the programming means. Such a bipolar transistor is shown in Figure 1a. Transistor 9 is comprised of collector 13 of a semiconductor material doped with an inpurity of a first conductivity type, base 12 which is doped with an impurity of a conductivity type opposite to that of collector 13, and emitter 11 which is doped with an impurity the same conductivity type as, but to a higher conductivity than collector 13. In this fashion, either an NPN or a PNP transistor is formed. In order to program this type of cell, sufficient emitter-collector current must be applied to form an electrical short (i.e., a low resistance path) between emitter 11 and collector 13 through base 12. This short is shown in Figure 1b and is labeled 14. Typical emitter-collector currents required to form short 14 depend upon a variety of factors (such as base doping concentration and base width) and are in the range of 70 to 150 milliamps. It is therefore generally recommended by manufacturers of such PROMs that a programming current on the order of 200 milliamps be used, in order to ensure that desired shorts are formed, thereby programming desired cells. Due to the high programming current required, access devices associated with the programming means of each cell must be capable of handling such currents without themselves being physically damaged. For this reason, bipolar transistors are used as access devices in prior art PROM devices, due to their high current carrying ability.

Figure 2 shows a schematic diagram of a portion of a prior art PROM device utilizing bipolar transistors as the programming means. PROM device 100 contains bit lines $B_1$ and $B_2$, and word lines $W_1$ and $W_2$. The cell accessed by word line $W_1$ and bit line $B_1$ is labeled 11. The cell accessed by word line $W_1$ and bit line $B_2$ is labeled 12. Smilarly, the cell accessed by word line $W_2$ and bit line $B_1$ is labeled 21, and the cell accessed by word line $W_2$ and bit line $B_2$ is labeled 22. Each cell is similarly constructed, and thus the following discussion of cell 11 applies equally to all cells in the memory array 100.

Memory cell 11 comprises access transistor $T_{11}$ having collector 1, base 2, and emitter 3. Collector 1 is connected to bit line $B_1$, and base 2 is connected to word line $W_1$. Emitter 3 is connected to collector 4 of programming transistor $P_{11}$ as shown. Base 5 of programming transistor $P_{11}$ is floating, and emitter 6 is connected to bias line 91. Connected to bit line $B_1$ is sense amplifier $A_1$ having output terminal $O_1$.

During the programming of memory cell 11, a short is created between collector 4 and emitter 6 of programming

transistor $P_{11}$ in the following manner. Bias line 91 is connected to ground. Bit line $B_1$ is accessed by connecting to it a source of positive potential. All other bit lines at this time are kept low. Word line $W_1$ is accessed by applying a logical high. All other word lines are kept low at this time. With a high on word line $W_1$, access transistor $T_{11}$ turns on. The source of high potential connected to bit line $B_1$ is connected to collector 4 of programming transistor $P_{11}$ through access transistor $T_{11}$. Programming transistor $P_{11}$ conducts, due to the source of high potential being connected to its collector 4, causing reverse breakdown of the collector-base junction. With emitter 6 being connected to bias line 91, which is at ground, the base-emitter junction is forward biased. Programming transistor $P_{11}$ is constructed such that sufficient current is applied during programming from bit line $B_1$ to cause a permanent short to be created between collector 4 and emitter 6. Access transistor $T_{11}$ is constructed such that it can carry this programming current without itself becoming damaged. Each cell in memory array 100 which is desired to be programmed is programmed by this method.

During the read operation of memory cell 11, bias line 91 is connected to ground, bit line $B_1$ is accessed by applying a logical high, and word line $W_1$ is accessed by applying a logical high. With bit line $B_1$ and word line $W_1$ high, access transistor $T_{11}$ will conduct, applying the logical high from bit line $B_1$ to collector 4 of programming transistor $P_{11}$. If programming transistor $P_{11}$ has been programmed, the high applied to collector 4 will cause current to flow through the short created between collector 4 and emitter 6 of programming transistor $P_{11}$ to bias lead 91, which is at ground. The current flow through access transistor $T_{11}$ and programming transistor $P_{11}$ to ground causes bit line $B_1$ to be pulled low. This low is applied to sense amplifier $A_1$, resulting in an

output signal being applied to output terminal $O_1$ indicative of the fact that programming transistor $P_{11}$ has been programmed. On the other hand, if programming transistor $P_{11}$ had not been programmed, current would not flow between collector 4 and emitter 6 of programming transistor $P_{11}$, because base 5 is not high. Thus, when an unprogrammed cell 11 is accessed, bit line $B_1$ will remain high. This high is applied to amplifier $A_1$, and the output signal available at $O_1$ is indicative of memory cell 11 being unprogrammed.

The major difficulty associated with this prior art method of utilizing bipolar transistors as programming means is that each access transistor associated with a single programming transistor must be capable of carrying the high programming current without itself being damaged. Since the current required to program a bipolar transistor is on the order of 200 milliamps, the access transistor must be constructed to be rather large in order to be able to handle 200 milliamps without incurring any damage. This causes the size of each cell in the memory array to become rather large, and thus the size of the entire memory array, typically containing thousands of individual memory cells, becomes quite large. Since MOS transistors are typically unable to handle nearly as much current as a bipolar transistor of like size, programming currents in excess of about 50 mA effectively preclude the use of MOS technology for PROM structures of this type, due to the large size required of the MOS transistors.

Another prior art method of constructing PROMs is to utilize refractory metal, such as nichrome, or polycrystalline silicon in such a manner as to form a fusible link. Such a fusible link is shown in Figures 3a and 3b. Fusible link 71 contains narrowing 72 such that region 72 acts as a fuse. When sufficient current is caused to flow through narrowing 72, the material is melted, thus forming devices are inherent reliability risks that should be scrapped rather than utilized in a system. Such a burn-in technique does not eliminate the reliability problem of individual devices, or decrease the yield loss due to this grow-back phenomenon.

Prior art PROMs are generally constructed using bipolar techniques due to the higher current carrying abilities of bipolar transistors. While it is possible to utilize metal oxide silicon (MOS) access devices utilizing prior art PROM techniques, it is disadvantageous to do so, because MOS transistors must be made significantly larger than their bipolar counterparts for a given current carrying capacity. Prior art PROMs are disclosed for example, in United States Patents Nos. 3,191,151; 3,733,690; 3,742,592 and 3,848,238.

SUMMARY OF THE INVENTION

This invention overcomes prior art difficulties in the manufacture of programmable read only memories by utilizing a lateral diffused zener diode as the programming means. Such a technique allows currents required to program each cell to be significantly reduced over the programming currents required in prior art devices. This reduction in programming currents allows a significant reduction in the size of the access transistor required for each memory cell, thereby allowing an entire memory array to be reduced significantly in size. Furthermore, the quality and reliability problems associated with prior art fusible link technology is eliminated. This invention also allows each cell to be reduced in size over prior art memory cells, due to the fact that the program means used is a zener diode, rather than larger bipolar transistors or fusible links.

opening 73 as shown in Figure 3b. The circuit of Figure 2 can be used to construct a PROM utilizing fusible links, where each programming transistor $P_{11}$, $P_{12}$, $P_{21}$, and $P_{22}$ is replaced by a single fusible link. Programming and reading takes place in precisely the same manner as in the circuit shown in Figure 2, with the exception that programmed cells contain open fuses rather than shorted transistors. Typical current required to blow open a fusible link is again on the order of 70 to 200 milliamps. Thus, this technique also requires that each access transistor be rather large in order to carry the current required to program each fusible link without itself incurring any damage.

While many manufacturers prefer fusible link technology, there are inherent quality, manufacturing and reliability problems in this technology. First, the width and thickness of fusible links must be precisely controlled to ensure that each fusible link which is desired to be programmed will blow under specified programming currents. If a fusible link becomes too thick or too wide, the quality of the device will be poor because the fusible link will not blow open under specified programming currents, thereby causing a bit failure in the memory array. The inherent reliability problem in fusible link technology is that even for fusible links which satisfactorily blow open during programming, there is the possibility that a blown open fusible link will grow back together due to metal or polycrystalline silicon migration. If the link grows back, it is no longer an open circuit, and therefore changes the cell's characteristics from being a programmed cell to being an unprogrammed cell. While devices prone to this grow-back phenomenon may be screened out after programming by standard well-known burn-in techniques, which simulate a lengthy period of operation over a short period of time by accelerated life testing, this method is expensive and simply identifies which

In one embodiment, the access means for each cell is a diode, further reducing the cell size over cells utilizing bipolar or MOS transistors as access devices. Finally, due to the use of zener diodes as the programming means in this invention, the number of process steps in the fabrication of PROMs of this invention is reduced over the number of process steps in prior art techniques utilizing fusible links, wherein specific additional process steps are required to fabricate PROMs. No additional process steps are required in the fabrication of devices in accordance with this invention, as compared to standard prior art metal oxide silicon (MOS) processes.

BRIEF DESCRIPTION OF THE DRAWING

Figures 1a and 1b show in cross-section a prior art bipolar transistor used as a programming means both before and after programming.

Figure 2 is a schematic diagram of a prior art circuit utilized in the construction of programmable read only memories.

Figures 3a and 3b show a fusible link typically used in prior art PROMs, both before and after programming.

Figure 4 is a cross-sectional view of a prior art vertical zener diode.

Figure 5 is a cross-sectional view of a prior art lateral zener diode.

Figure 6 is a top view of one zener diode design suitable for use in memory cells constructed in accordance with this invention.

Figure 7 is a top view of a second zener diode design suitable for use in memory cells constructed in accordance with this invention.

Figures 8a and 8b are schematic diagrams of two memory cells constructed in accordance with the present invention.

Figure 8c is a top view of one embodiment of this invention.

Figure 8d is a cross-sectional view of the structure of Figure 8c, taken along line 8d-8d.

Figure 9 is a schematic diagram of a memory cell of yet another embodiment of this invention.

Figure 10 is a cross-sectional view of an embodiment of this invention which utilizes a parasitic bipolar transistor in CMOS structures as an access device.

Figure 11 is a schematic diagram of the memory cells of Figure 10.

DETAILED DESCRIPTION OF THE INVENTION

This invention utilizes zener diodes as the programming means, in contrast to prior art methods of constructing PROMS which utilize either a bipolar transistor or a fusible link as the programming means. Figure 4 shows a cross-sectional view of a typical zener diode used in semiconductor circuits. P region 112 is formed within substrate 111 as shown. Within P region 112, N+ region 113 is formed. Because N+ region 113 is contained within P region 112, this type of zener diode is known as a vertical zener diode. The zener diode junction 119 is formed between N+ region 113, which serves as the cathode, and P region 112, which serves as the anode.

A lateral zener diode is shown in Figure 5. P region 122, which serves as the anode, is formed within substrate 121. Similarly, N+ region 123, which serves as the cathode, is formed adjacent to region 122 as shown. Zener junction 129 is formed at the interface between anode 122 and cathode 123. Generally, in applications where the diodes are not to be "burned out", vertical zener diodes are preferred over lateral zener diodes in that they are less prone to damage due to excessive voltages or currents being applied to the zener diode, and may be made smaller than lateral zener diodes for a given current carrying capacity. Thus, most semiconductor manufacturers have designed their circuits to utilize vertical zener diodes rather than lateral zener diodes in applications where the regulating or clamping characteristics of zener diodes are desired.

In accordance with this invention, a zener diode is used as a novel programming means in a PROM device, thereby allowing a reduction in cell size over the cell size in prior art structures which utilize a larger bipolar transistor as the programming means. In accordance with another aspect of this invention a zener diode is provided that is capable of being programmed, i.e., shorted, with the least amount of current, thereby allowing each cell's accessing means to be reduced in size, due to its decreased current handling requirements as compared with prior art PROM circuits. Several lateral zener diodes were constructed to determine their programming characteristics.

One such lateral zener diode is shown in top view in Figure 6. The substrate is a ⟨100⟩ silicon wafer having an N conductivity type of approximately 3-5 ohm-cm. This diode is formed utilizing standard masking techniques, and the following process. A highly N+ doped layer of silicon dioxide containing approximately 7% phosphorus is deposited above the to-be-formed cathode to a thickness of approximately 4000 angstroms, utilizing well-known techniques. This silicon dioxide layer is covered with a layer of approximately 2000 angstroms of undoped silicon dioxide. The total thickness of these two layers is within the range of approximately 5400 to 6600 angstroms. The anode is formed by subjecting the to-be-formed anode region, which is not masked by silicon dioxide, to a P+ Boron predeposition utilizing $BBr_3$ as a Boron source (other P+ doping sources may be used). This is accomplished by a 5 minute push (the time it takes to insert a boat of wafers into a furnace), followed by an 8 minute soak, to allow the wafers to reach a uniform temperature, followed by a 5 minute source (where the wafers are subjected to the $BBr_3$ Boron source), and a 3 minute pull (removal of boat from the furnace). The furnace temperature is maintained at approximately 1025°C during the predeposition, where both Phosphorous (from the doping vapox) and Boron are simultaneously diffused. The Boron predeposition results in a V/I of approximately $7 \pm 1/2$ ohms. Because of this doping method of simultaneous N+ and P+ doping, a self-aligned (no mask misalignment) lateral zener diode is formed where desired, thus there is no additional process steps required to fabricate these zener cells, unlike other prior art cells which require additional processing and masking steps.

The deposited Phosphorous doped silicon dioxide is then removed by standard etch methods. The anode and cathode dopants are then diffused to the desired depth of approximately 1.2 microns by a reoxidation of both anode and cathode regions by subjecting the wafer to dry $O_2$ at approximately 950°C utilizing a 5 minute push, 40 minute soak and 5 minute pull, plus subsequnt heat treatment, such as the well-known oxide reflow techniques. This results in a silicon dioxide layer of approximately 400 $\pm$ 75 angstroms.

Contacts 315 and 316 provide a metallic (preferably aluminum) interconnection to regions 311 and 312, respectively, thereby allowing simple and efficient connection to external test instrumentation. Junction 319 is formed between regions 311 and 312 of opposite conductivity types, thereby forming the zener diode junction. The length of junction 319, labelled "1" in Figure 6, also referred to "edge", is preferably 3 microns or less. This junction is destroyed by a current of approximately 15 milliamps at approximately 14 volts. Initial device testing was done with an "edge" dimension of 10 microns; these devices would "program" at about 50 mA with about 18 volts applied.

A lateral zener diode of a second configuration is shown in Figure 7. Region 312 is formed of a first conductivity, and region 311 is formed within region 312, to the opposite conductivity. Contacts 315 and 316 are formed to provide interconnection with regions 311 and 312, respectively. Junction 329 is formed between regions 311 and 312. Devices are constructed in this fashion, having 60 microns of edge (therefore the perimeter of region 311 is 60 microns), utilizing the same starting material and process parameters as the device of Figure 6.

Test data for three lateral zener diodes constructed to determine their characteristics, and thus their suitability as programming means in a PROM, is given in Attachments 1 to 3. The zener diode labeled "P4" is constructed as shown in Figure 6, having 10 microns of edge process. The zener diode labeled "P5" is constructed as shown in Figure 7 having 60 microns of edge, with region 311 being doped to an N+ conductivity to serve as the cathode, and region 312, serving as the anode, being doped to a P+ conductivity process. The zener diode labeled "P6" is constructed as shown in Figure 7 with 60 microns of edge, with region 311 being doped to a P+ conductivity and serving as the anode, and region 312 being doped to an N+ conductivity and serving as the cathode. As the data in Attachment 1 indicates, device P4 requires the lowest power to become programmed, or shorted. Reliable programming can be achieved for zener diodes contructed in this fashion utilizing a programming voltage of 15-19 volts and a programming current of only 45-54 milliamps. This programming current is considerably less than the 70-200 milliamps required to program prior art PROMs. Furthermore, utilizing the present 5 micron technology which is readily available in the semiconductor industry, the edge of a zener diode constructed as shown in Figure 6 can be reliably made as narrow as 2-3 microns. This decrease in edge length will further reduce the power requirements during programming of a cell utilizing a zener diode as the programming means. Test data for zener diodes constructed in a manner similar to device P4 and having 5, 4, 3 and 2 microns of edge is given in Attchments 4, 5, 6 and 7, respectively.

Typical depth for zener diodes constructed in the manner described for zener diode P4 is approximately 1.2 microns. The depletion spread during reverse bias totals approximately .15 microns on both sides of the zener junction (approximately .075 microns on each side of the junction). For a zener diode having a junction width (edge) of 2 microns, the volume in which the zener action occurs is thus approximately .36 cubic microns. Assuming a programming voltage of 6 volts (at the chemical junction, ignoring IR drop) and a programming current of 15 milliamps, the power available for destroying the zener diode and forming a short during programming is thus 90 milliwatts. This is equivalent to approximately 2.5 watts per cubic micron, which is adequate to cause permanent damage to the zener diode by causing aluminum migration from contacts 315 and 316 of Figure 6, through the semiconductor substrate, across junction 319, thus forming a permanent short. Of importance, this short is formed by aluminum migrating through the semiconductor PN junction, thus forming a reliable short circuit as opposed to prior art PROMs utilizing fusible links, in which the fusible material is located on the surface of the substrate. Contrary to the PROMs of this invention, prior art fusible link PROMs are subject to "growback" due to migration of fusible material located on the surface of the die, where electromigration is possible over a period of time under normal operating conditions. Thus, the PROMs of this invention do not exhibit the reliability problems associated with prior art fusible link PROMs. The quality of PROM devices utilizing zener diodes as the programming means is also improved over prior art fusible link devices, because the characteristics of zener diodes are more highly controllable during fabrication processes than are the charactertistics of fusible links.

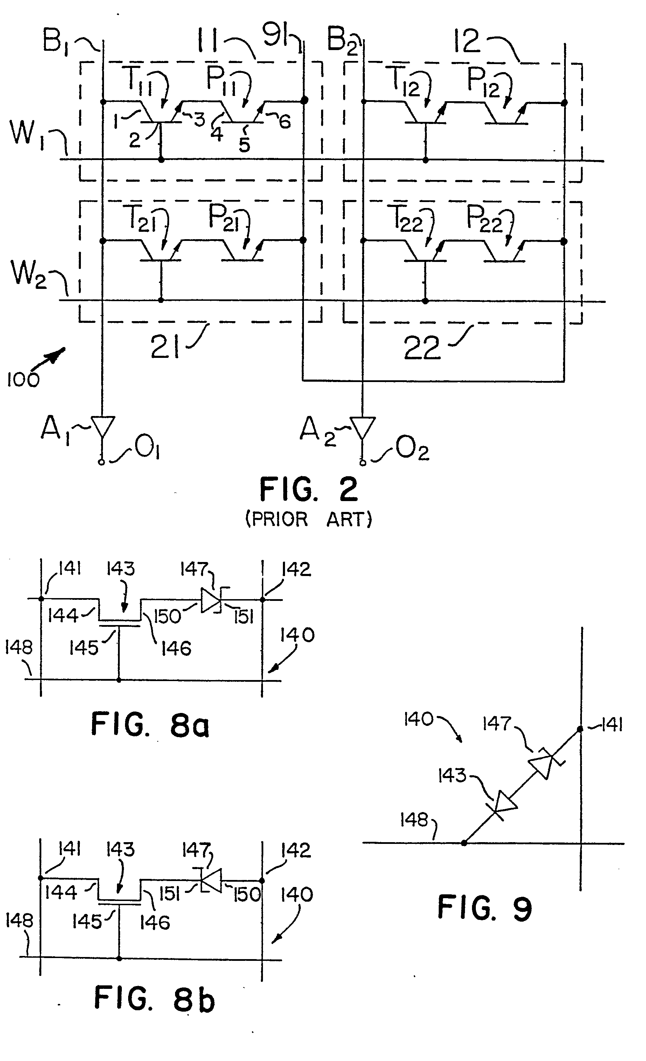

One example of a memory cell constructed in accordance with this invention is shown in the schematic diagram of Figure 8a. Memory cell 140 is comprised of word line 141, power line 142, and bit line 148. N channel MOS access transistor 143 has its source 144 connected to word line 141, its gate 145 connected to bit line 148, and its drain 146 connected to anode 150 of programming means zener diode 147. Cathode 151 of zener diode 147 is connected to power line 142 as shown.

During the programming of the memory cell as shown in Figure 8a, power line 142 is connected to a source of positive potential. Cell 140 is accessed by forcing bit line 148 high and word line 141 low. With the high connected to bit line 148, access transistor 143 turns on, thereby applying the low from word line 141 to the anode 150 of zener diode 147. With the high voltage applied to power line 142, zener diode 147 conducts from cathode 151 to anode 150 via zener breakdown. Sufficient current is forced through zener diode 147 to destroy it (i.e., short its PN junction).

During the read operation of the memory cell of Figure 8a, the cell is accessed by applying a high to bit line 148 and a low to word line 141. Power line 142 is maintained high, but at a voltage level (5 volts, for example) less than that applied to power line 142 during programming. During the read operation, the high applied to word line 148 causes access transistor 143 to conduct. If cell 140 has been programmed, zener diode 147 will be a short circuit of very low resistivity, and the high from power line 142 will be applied to word line 141. A sense-amplifier (not shown) connected to word line 141 detects this high and provides an output signal indicative of the fact that cell 140 has been programmed. Conversely, if memory cell 140 has not been programmed, zener diode 147 will remain an open circuit, because the positive voltage applied to power line 142 during the read operation is insufficient to cause zener breakdown of zener diode 147. Thus the high from power line 142 is not connected to word line 141 and word line 141 remains low. The sense amplifier connected to word line 141 detects this low and provides an output signal indicative of the fact that memory cell 140 has not been programmed.

Another embodiment of memory cell 140 of this invention is shown at Figure 8b. Principles of operation of this circuit are similar to those of the circuit of Figure 8a just discussed, with the exception that zener diode 147 is reversed as shown. Utilizing an N channel access transistor 143, power line 142 is connected to ground during programming, and word line 141 is connected high during programming and reading. This approach allows smaller cell construction in that a single N doped region may serve as source 146 of access transistor 143 and cathode 151 of zener diode programming means 147. However, in the circuit of Figure 8b, access transistor 143 is a source follower, which has the disadvantage of having less gain than the common source configuration of Figure 8A due to body bias coefficient. In this embodiment (a source follower configuration) a parasitic junction field effect transistor is formed between the substrate and gate 145 of access transistor 143, thus tending to pinch off the channel. In common source circuits, the load (zener) is connected between ground and the source with the drain being most positive, thus eliminating the tendency of the parasitic JFET to pinch off the channel (as shown in Figure 8a).

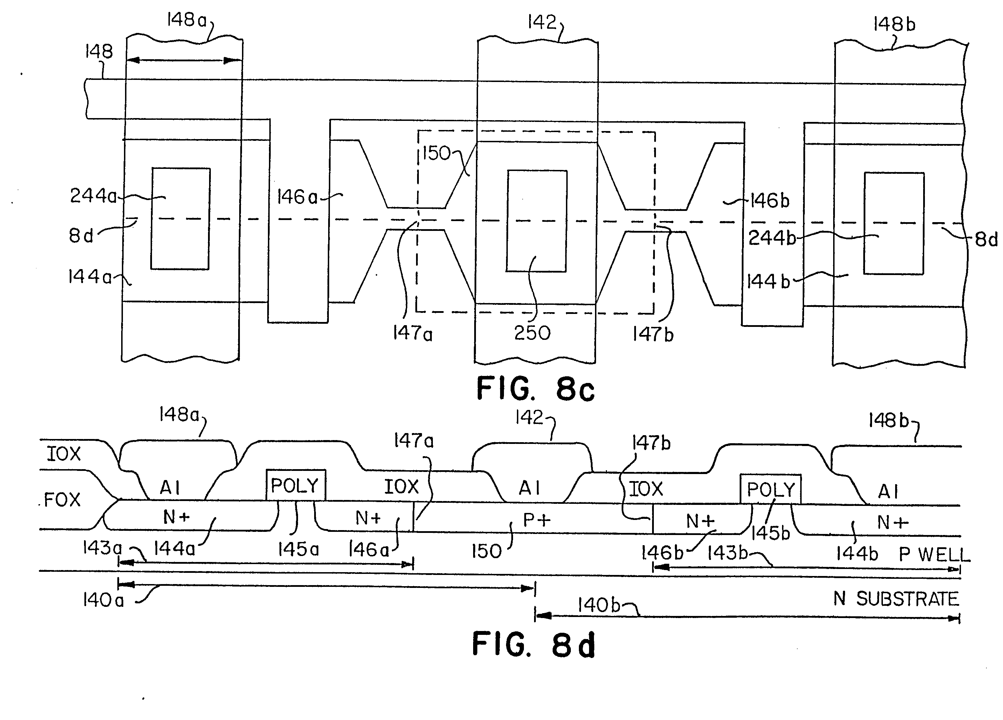

Figure 8c is a top view of two adjacent memory cells constructed in accordance with the embodiment of this invention shown in Figure 8b. Figure 8d is a cross-sectional view of the structure of Figure 8c, taken along line 8d-8d. Word line 148 forms gate 145a of access transistor 143a, and gate 145b of access transistor 143b. Bit line 148a is connected through contact 244a to N+ region 144a which serves as the drain of access transistor 143a. Similarly, bit line 148b is connected through contact 244b to N+ region 144b which serves as the drain of access transistor 143b. Sources 146a and 146b are formed adjacent to P+ region 150, thereby forming two back-to-back zener diodes having junctions 147a and 147b. These two common anode zener diodes form the programming means for cell 140a and cell 140b, respectively. Connected to anode 150 through contact 250 is program line 142.

The embodiment shown in Figures 8c and 8d is particularly suited for use in manufacturing highly dense PROMS because the zener diodes to be programmed in two adjacent memory cells share a common anode 150.

To those skilled in the art, the memory cells of Figures 8a and 8b may be constructed utilizing N channel, P channel, CMOS and bipolar accessing transistors. Similarly, word lines 141 and power lines 142 may be interchanged without destroying the principals of this invention. N channel access transistors are preferred over P channel access transistors due to the greater current carrying ability of an N channel transistor compared to a P channel transistor of the same size. This greater current carrying ability is caused by the greater mobilities of electrons, which form the N channel, than holes, which form the P channel.

Utilizing an N channel access transistor 143 in the circuit of Figure 8 is a practical approach. However, if a P channel access transistor 143 is utilized, the same P region may serve as source 146 of access transistor 143 and anode 150 of zener diode 147 in Figure 8a. However, using a P channel access transistor 143 in a source follower configuration requires access transistor 43 to be slightly larger with its decreased gain over common source circuits.

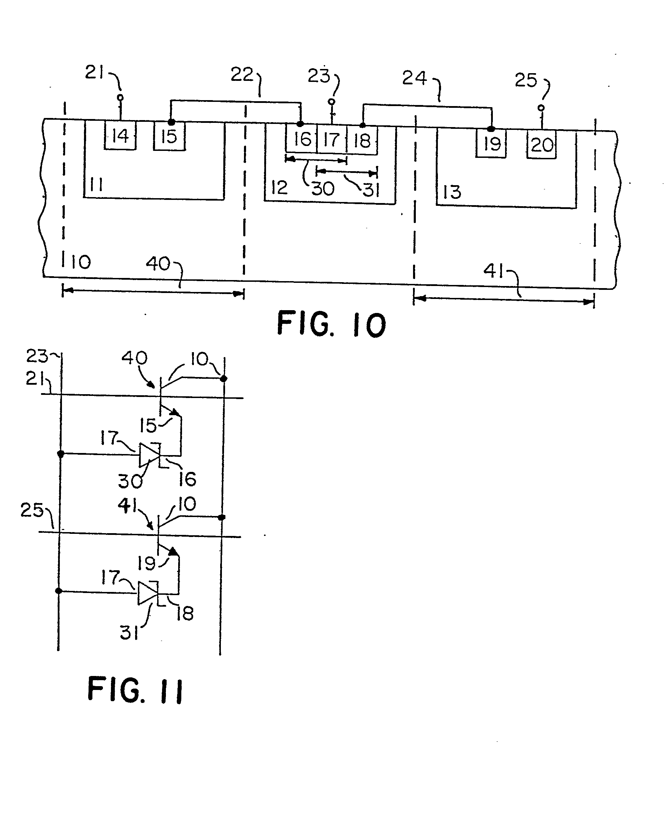

Another embodiment of this invention is shown in the circuit of Figure 9. As shown, this embodiment utilizes zener diode 147 as the programming means, and diode 143 as the access means for cell 140. This is in contrast to prior art circuits such as disclosed in United States Patent Number 3,191,151, where semiconductor diodes are used as the programming means, as opposed to the use in this invention of zener diodes which are programmed with very low power. During programming of this cell 140, the cell is accessed by placing a low on bit line 148 and a high on word line 141. The high potential placed on word line 141 is sufficient to cause programming means zener diode 147 to short out. During the read operation of memory cell 140 of Figure 9, a high is again placed on word line 141; however, this high potential is selected to be insufficient to cause a zener breakdown of an unprogrammed zener diode 147. Thus, for a programmed cell 140, the high applied to word line 141 will be applied through shorted zener diode 147 to access diode 143, which will become forward biased, thereby connecting the high to bit line 148. Conversely, for an unprogrammed memory cell 140, the high placed on word line 141 will be insufficient to cause a zener breakdown of zener diode—147, and thus will not cause access diode 143 to be forward biased, and thus will not cause bit line 148 to go high. A sense amplifier connected to bit line 148 (not shown) will provide an output signal indicative of whether memory cell 140 is a programmed or an unprogrammed cell. In a similar fashion, zener diode access means 143 may be replaced with a semiconductor diode, rather than a zener diode.

Another embodiment of this invention is shown in the cross-sectional view of Figure 10, and the corresponding schematic diagram of Figure 11. Into N- substrate 10 are formed P- wells 11, 12 and 13. Contact is made between terminal 21 and P- well 11 via P+ contact 14. N+ region 15 is also formed within P- well 11. NPN bipolar transistor 40 is formed with substrate 10 serving as common collector, P- well 11 serving as the base, and N+ region 15 serving as the emitter. A similar NPN bipolar transistor 41 is formed with substrate 10 serving as the collector, P- well 13 serving as the base, and N+ region 19 serving as the emitter. P+ contact 20 is used to connect base terminal 25 to base region 13. Two common anode zener diodes 30 and 31 are formed within P- well 12 by N+ regions 16 and 18, and P+ region 17 formed therebetween. The schematic diagram of Figure 11 shows the two memory cells contained in Figure 10. Base terminal 21 is connected to word line 21 of Figure 11. Similarly, base terminal 25 of Figure 10 is connected to word line 25 of Figure 11. Collectors 10 are connected in common to lead 10, which is the substrate. Bit line 23 is connected to P+ region 17 which forms the anode of zener diodes 30 and 31. Cathode 16 of zener diode 30 is connected to emitter 15 of transistor 40, and Cathode 18 of zener diode 31 is connected to emitter 19 of transistor 41. This technique allows the use of a parasitic bipolar transistor which is present in CMOS structures, thus allowing smaller cell size when fabricated with a CMOS process which uses epitaxial substrate material (with its resulting low collector saturation resistance) than circuits utilizing MOS transistors as the access device. Utilizing a parasitic bipolar access transistor, and 5 micron technology presently available to the semiconductor industry, a memory cell of approximately 6 square mils may be formed.

The zener diodes used in each embodiment of this invention may be either diffused zener diodes, ion-implanted zener diodes, or polycrystalline silicon zener diodes which are formed on the surface of the silicon wafer. Diffused ion-implanted and polycrystalline silicon zener diodes may be constructed as either lateral or vertical diodes. Typical thicknesses for diffused and ion implanted zener diodes are on the order of 1.2 microns or less. Typical thicknesses for polycrystalline silicon zener diodes are on the order of .4 microns or less. Thus, because of their smaller junction area resulting from their small thickness, polycrystalline silicon diodes can be destroyed, or programmed, with less power. Thus, while utilizing diffused zener diodes as a programming means in accordance with this invention will result in memory cells requiring significantly lower programming currents, and thus access means of smaller physical size than prior art techniques, the use of polycrystalline silicon zener diodes as a programming means in accordance with this invention will result in still further reductions in programming currents required, and thus access means of even smaller size than either prior art circuits, or circuits constructed in accordance with this invention utilizing diffused zener diodes.

As cell size decreases, the size of associated bit lines, word lines and power lines also decreases. For sufficiently small cells, these conductive lines must be formed of metal, with a typical resistivity of approximately 0.1 ohms/square or less. Polycrystalline silicon cannot be used as conductive lines in very small structures, because its resistivity is approximately 30-40 ohms/square which results in excessive IR drops, thus preventing sufficient current flow to program desired cells.

Other embodiments of this invention will be obvious to those skilled in the semiconductor arts in view of this disclosure.

## DEVICE P4

| WAFER NUMBER | FORWARD BIAS VOLTAGE DROP (VOLTS) | ZENER BREAKDOWN VOLTAGE (VOLTS) | PROGRAMMING VOLTAGE (VOLTS) | PROGRAMMING CURRENT (MILLIAMPS) |
|---|---|---|---|---|
| 40201-9 | 0.58 | 6 | 40 | 50 |
|  | 0.56 | 6 | 22 | 50 |
|  |  |  | 20 | 53 |
|  |  |  | 17.5 | 43 |
|  |  |  | 19 | 52 |
|  |  |  | 19 | 53 |
|  |  |  | 19 | 53 |
|  |  |  | 17 | 52 |
| 40210-10 |  |  | 20 | 50 |
|  | 0.56 | 6 | 20 | 50 |
|  | 0.56 | 6 | 15 | 45 |
|  |  |  | 20 | 54 |
|  |  |  | 15 | 52 |
|  |  |  | 16 | 48 |
|  |  |  | 16 | 48 |
| 40209-6 |  |  | 17 | 50 |
|  | 0.56 | 5.8 | 16 | 50 |
|  | 0.56 | 6 | 18 | 52 |
|  | 0.57 | 6 | 18 | 50 |
|  |  |  | 19 | 52 |
|  |  |  | 19 | 54 |
|  |  |  | 15 | 52 |

## DEVICE P5

| WAFER NUMBER | FORWARD BIAS VOLTAGE DROP (VOLTS) | ZENER BREAKDOWN VOLTAGE (VOLTS) | PROGRAMMING VOLTAGE (VOLTS) | PROGRAMMING CURRENT (MILLIAMPS) |
|---|---|---|---|---|
| 40201-9 | 0.52 | 5.5 | 0.92 | 118 |
|  | 0.52 | 5.5 | 11 | 124 |
|  |  |  | 11 | 124 |
| 40210-10 | 0.52 | 5.5 | 12 | 120 |
|  | 0.53 | 5.2 | 11.5 | 120 |
| 40209-6 | 0.52 | 5.3 | 11 | 120 |
|  | 0.52 | 5.4 | 11 | 122 |
| 40210-1 | 0.5 | 4.8 | 11 | 120 |
|  | 0.52 | 4.8 | 11 | 120 |

DEVICE P6

| WAFER NUMBER | FORWARD BIAS VOLTAGE DROP (VOLTS) | ZENER BREAKDOWN VOLTAGE (VOLTS) | PROGRAMMING VOLTAGE (VOLTS) | PROGRAMMING CURRENT (MILLIAMPS) |
|---|---|---|---|---|
| 40101-9 | 0.55 | 5.4 | 12 | 100 |
|  | 0.53 | 5.3 | 11 | 120 |
|  |  |  | 11 | 120 |
| 40210-10 | 0.55 | 5.3 | 11 | 120 |
|  | 0.53 | 5.4 | 11.3 | 120 |
| 40209-6 | 0.55 | 5.4 | 10.5 | 124 |
|  | 0.53 | 5.4 | 10.3 | 122 |
| 40210-1 | 0.55 | 4.8 | 11 | 117 |
|  | 0.55 | 4.8 | 10.5 | 120 |

## 5 MICRON EDGE

| Programming current at 15 volts (No Series Resistance) | | Programming voltage and current ($\approx 200\,\Omega$ Series Resistance |  |
|---|---|---|---|
| No. of Devices | Milliamps | Volts | Milliamps |
| 4 | 20 | 16.5 | 24 |
| 4 | 21 | 16 | 23 |
| 7 | 22 | 16 | 22 |
| 7 | 23 | 15.5 | 20 |
|  |  | 15.5 | 22 |
| 6 | 24 | 15 | 25 |
| 8 | 25 | 15 | 25 |
|  |  | 15 | 25 |
|  |  | 15 | 25 |
|  |  | 15 | 24 |
|  |  | 15 | 23 |
|  |  | 14.5 | 25 |

## 4 MICRON EDGE

| Programming current at 15 volts (No Series Resistance) | | Programming voltage and current ($\approx 200\,\Omega$ Series Resistance) | |
|---|---|---|---|
| No. of Devices | Milliamps | Volts | Milliamps |
| 5 | 16 | 16 | 19 |
| 5 | 17 | 16 | 18 |
| 5 | 18 | 16 | 16 |
| 7 | 19 | 15.5 | 20 |
| 13 | 20 | 15 | 20 |
| | | 15 | 20 |
| 1 | 21 | 15 | 20 |
| | | 15 | 19 |
| | | 15 | 19 |
| | | 15 | 19 |
| | | 15 | 17 |
| | | 14.5 | 21 |

## 2 MICRON EDGE

Programming current
at 15 volts
(No Series Resistance)

Programming voltage
and current
($\approx 200 \, \Omega$ Series Resistance)

| No. of Devices | Milliamps | Volts | Milliamps |
|---|---|---|---|
| 1 | 7 | 17 | 10 |
| 3 | 8 | 16.5 | 9 |
| 7 | 9 | 15 | 10 |
| 19 | 10 | 16 | 10 |
| 3 | 11 | 16 | 10 |
| 2 | 12 | 16 | 9 |
| 1 | 13 | 16 | 9 |
| | | 15.5 | 10 |
| | | 15 | 12 |
| | | 15 | 12 |
| | | 15 | 11 |
| | | 15 | 8 |

## 3 MICRON EDGE

| Programming current at 15 volts (No Series Resistance) | | Programming voltage and current ($\approx$ 200$\Omega$ Series Resistance) | |
|---|---|---|---|
| No. of Devices | Milliamps | Volts | Milliamps |
| 3 | 12 | 17 | 14 |
| 3 | 13 | 16 | 15 |
| 5 | 14 | 15.5 | 15 |
| 21 | 15 | 15.5 | 15 |
| 3 | 16 | 15.5 | 15 |
| | | 15.5 | 15 |
| | | 15 | 17 |
| | | 15 | 16 |
| | | 15 | 15 |
| | | 15 | 15 |
| | | 15 | 15 |
| | | 15 | 15 |

0054740

1.  A programmable read only memory cell capable of storing a single bit comprised of:

a bit line;

a word line;

means for supplying power; and

means connected to said bit line and to said word line comprising a zener diode having a first and second terminal serving as a programming means, and an access means having first and a second current handling terminals connected in series with said programming means, said access means having a control terminal connected to said word line.

2.  Structure as in claim 1 wherein said first current handling terminal of said access means is connected to said word line, said second current handling terminal of said access means is connected to said first terminal of said programming means, said second terminal of said programming means is connected to said means for supplying power, and said terminal of said access means is connected to said bit line.

3.  The structure as in claim 2 including means for programming said cell by applying a voltage to said bit line sufficient to cause said access means to conduct, and applying a voltage between said word line and said means for supplying power in excess of the zener breakdown voltage of said zener diode sufficient to cause zener breakdown and excessive current flow through said zener diode resulting in the formation of a permanent short circuit across said zener diode.

4. Structure as in claim 3 including means for reading said cell by applying a voltage to said bit line sufficient to cause said access means to conduct, and applying a voltage less than the zener breakdown voltage of said zener diode between said word line and said means for supplying power such that current will flow between said bit line and said power line through said access means and said zener diode if said zener diode has been shorted, and current will not flow between said word line and said power line if said zener diode has not been shorted.

5. Structure as in claim 4 wherein said power line is the semiconductor substrate.

6. Structure as in claim 4 wherein said access means is an N channel MOSFET.

7. Structure as in claim 4 wherein said access means if a P channel MOSFET.

8. Structure as in claim 4 wherein said access means is an NPN bipolar transistor.

9. Structure as in claim 4 wherein said access means is a PNP bipolar transistor.

10. Structure as in claim 4 wherein said access means is a complementary metal oxide silicon device.

11. A programmable read only memory cell capable of storing a single bit, comprising:

a bit line;

a word line; and

means connected to said bit line and said word line comprising a diode serving as an access means and a sener diode serving as a programming means connected in series with, and having plurality opposite said access means.

12. Structure as in Claim 11 including means for programming said cell by connecting a voltage between said bit line and said word line in excess of the zener breakdown voltage of said zener diode sufficient to cause zener breakdown and excessive current flow resulting in the formation of a permanent short circuit across said zener diode.

13. Structure as in claim 12 including means for reading said cell by applying a voltage less than the zener breakdown voltage of said zener diode between said word line and said bit line such that current will flow between said bit line and said word line through said semiconductor diode under forward bias and said zener diode if said zener diode has been shorted, and current will not flow between said bit line and said word line of said zener diode has not been shorted.

14. Structure as in claim 13 wherein said cathode of said access means is connected to said bit line, said cathode of said programming means is connected to said word line, and said anode of said access means is connected to said anode of said programming means.

15. Structure as in claim 13 wherein said anode of said access means is connected to said bit line, said anode of said programming means is connected to said word line, and said cathode of said access means is connected to said cathode of said programming means.

16. Structure as in claims 4 or 15 wherein said zener diode is a lateral diffused zener diode.

0054740

17. Structure as in claims 4 or 15 wherein said zener diode is a vertical diffused zener diode.

18. Structure as in claims 4 or 15 wherein said zener diode is a lateral polycrystaline silicon zener diode.

19. Structure as in claims 4 or 15 wherein said zener diode is a vertical polycrystaline silicon zener diode.

20. Structure as in claims 4 or 15 wherein said zener diode is a vertical ion-implanted zener diode.

21. Structure as in claims 4 or 15 wherein said zener diode is a lateral ion-implanted zener diode.

FIG. Ia
(PRIOR ART)

FIG. 4
(PRIOR ART)

FIG. Ib
(PRIOR ART)

FIG. 5
(PRIOR ART)

FIG. 3a
(PRIOR ART)

FIG. 6

FIG. 3b
(PRIOR ART)

FIG. 7

0054740

FIG. 2
(PRIOR ART)

FIG. 8a

FIG. 8b

FIG. 9

0054740

FIG. 8c

FIG. 8d

FIG. 10

FIG. 11